# EUROPÄISCHE PATENTSCHRIFT

(11) **EP 0 986 828 B1**
(45) Veröffentlichungstag und Bekanntmachung des Hinweises auf die Patenterteilung: **05.03.2008**
(21) Anmeldenummer: 98925540.1
(22) Anmeldetag: 06.05.1998
(51) Int. Cl.: H01L 39/24

(54) **FORMKÖRPER AUS TEXTURIERTEM SUPRALEITERMATERIAL UND VERFAHREN ZU IHRER HERSTELLUNG**
SHAPED BODY CONSISTING OF TEXTURED SUPRACONDUCTOR MATERIAL AND METHOD FOR PRODUCING THE SAME
CORPS DE MOULAGE EN MATERIAU SUPRACONDUCTEUR TEXTURE ET PROCEDE PERMETTANT DE LE PRODUIRE

(30) Priorität: 02.06.1997 DE 19722779
(43) Veröffentlichungstag der Anmeldung: 22.03.2000
(73) Patentinhaber: Nexans SuperConductors GmbH, 50351 Huerth (DE)
(72) Erfinder: RIEDEL, Günter, D-65779 Kelkheim (DE); NEUMANN, Jürgen, D-65779 Kelkheim (DE); BOCK, Joachim, D-50374 Erftstadt (DE); GAUSS, Stephan, D-65843 Sulzbach (DE)
(74) Vertreter: Feray, Valérie
(86) Internationale Anmeldenummer: PCT/EP1998/002660
(87) Internationale Veröffentlichungsnummer: WO 1998/056048

(56) Entgegenhaltungen:
- WO-A-89/06053
- WO-A-96/21951
- US-A- 5 594 932

## Beschreibung

Die Erfindung betrifft ein Verfahren zur Herstellung von Formkörpern, die texturiertes Supraleitermaterial enthalten, und die Weiterverarbeitung dieser Formkörper zu massiven hochtemperatursupraleitenden Bauteilen wie z.B. Stromzuführungen bzw. zu hochtemperatursupraleitenden Bändern und Drähten nach der Pulver-in-Rohr-Methode (= Oxide-Powder-in-Tube-Methode, OPIT).

Aufgrund der heute noch zu geringen Stromtragfähigkeiten vieler hochtemperatursupraleitender Bauteile ist deren Einsatz begrenzt. Eine Weiterentwicklung derartiger Bauteile ist erforderlich, damit noch größere Ströme durch diese Bauteile supraleitend fließen können. Für die Herstellung von Hochtemperatursupraleitern hoher Stromtragfähigkeit ist es erforderlich, das hochtemperatursupraleitende Material bezüglich Reinheit, Phasenreinheit, Phasenzusammensetzung, Kristallisationsgrad und Orientierung zu optimieren.

Bei der Formgebung länglicher Formkörper wird üblicherweise das kaltisostatische Pressen (Cold Isostatic Pressing = CIP) nach dem Naßmatrizenverfahren (Wet Bag-CIP) angewendet, bei dem die Preßkräfte von allen Seiten auf die Formkörper wirken, wobei nur eine schwache oder eine uneinheitliche Ausrichtung der Partikel auftritt.

Bei dem Naßmatrizenverfahren wird eine dünnwandige, flexible Gummi- oder Kunststofform mit Pulver gefüllt und nach dem Verschließen dieser Form in einen Druckbehälter eingebracht. Die Verdichtung zu Formkörpern wird über ein flüssiges Druckübertragungsmedium bei vorgegebenem Druck erreicht. Enge Maßtoleranzen, wie sie insbesondere für das Einbringen der Formkörper in Silberhüllrohre beim OPIT-Verfahren erforderlich sind, lassen sich hierbei nicht erzielen, so daß eine Nachbearbeitung z.B. durch Drehen der Formkörper auf einer Drehbank nötig ist.

Dieser zusätzliche Arbeitsschritt bedingt einen erhöhten Prozeß- und Kostenaufwand sowie die Gefahr einer Erhöhung des Restkohlenstoffgehaltes im Produkt insbesondere bei kleinen Partikelgrößen infolge Wechselwirkung mit dem CO₂-Anteil der umgebenden Atmosphäre bei der mechanischen Bearbeitung. Besonders kleine Partikelgrößen sind aber gerade für das OPIT-Verfahren erwünscht.

Da beim Naßmatrizenverfahren allseitig Druck aufgebracht wird, kann keine einheitliche Vortexturierung der plättchenförmigen Partikel bewirkt werden. Mit den der Formgebung nachfolgenden mechanischen Behandlungsschritten z.B. bei der Band- und Drahtherstellung wie Extrudieren oder/und Walzen versucht man, die uneinheitliche Vortexturierung wieder auszugleichen. Dadurch werden viele Störstellen, Risse und Brüche in und zwischen den anorganischen Pulverpartikeln hervorgerufen. Diese führen zu vergleichsweise niedrigen Stromdichten oder erfordern lange Glühzeiten zur Ausheilung dieser Defekte, weil ein unbeeinträchtigter Stromfluß nur bei orientierten, direkt aneinandergrenzenden ungestörten Körnern der hochtemperatursupraleitenden Phase erfolgen kann.

Beim uniaxialen Pressen länglicher Formkörper z.B. in einer hydraulischen Presse richten sich die plättchenförmig ausgebildeten Pulverpartikel im wesentlichen senkrecht zur Preß- und damit senkrecht zur Längsrichtung des Formkörpers aus. Die Textur ist gerade um 90° verdreht gegenüber der optimalen Ausrichtung und wirkt sich besonders negativ auf den Stromfluß aus. Bei der optimalen Ausrichtung der Textur liegt die kristallographische (a,b)-Ebene, die parallel zur Plättchenebene und zur Ebene der maximalen Stromtragfähigkeit angeordnet ist, in der Richtung des Stromflusses im Bauteil. Bei den der Formgebung nachfolgenden thermischen Behandlungen bleibt die Vorzugsorientierung im wesentlichen erhalten.

Beim manuellen Befüllen von Metallrohren mit oxidischen Pulvern und bei der Verdichtung durch Stopfen anstelle maschinellen Pressens sind neben dem erhöhten Arbeitsaufwand auch die Inhomogenität der Preßdichte und die geringe Dichte des Formkörpers besonders nachteilig. Dies führt zu geringen supraleitenden Anteilen im Bauteil und zu besonders geringen Stromtragfähigkeiten.

EP-A-0 611 737 berichtet von einem Verfahren zur Herstellung von Supraleitern auf Basis (Pb,Bi)-(Sr,Ca)-Cu-O, bei dem zuerst eine oxidische Schmelze hergestellt und abgeschreckt wird und der gewonnene Schmelzregelus besonders fein zerkleinert wird.

In EP-A-0 396 581 wird ein Verfahren zur Herstellung von Drähten oder Bändern aus Supraleitermaterialien beschrieben, bei dem die Verdichtung des oxidischen Pulvers durch Kaltisostatisches Pressen im Naßmatrizenverfahren (Wet-Bag-CIP) erfolgt. WO-94/00886 führt ebenfalls ein Verfahren auf, bei dem nach dem Naßmatrizenverfahren isostatisch verdichtet wird.

WO-96/21951 lehrt ein Verfahren zur Herstellung eines länglichen supraleitenden Formkörpers entweder durch Extrudieren oder durch zwei aufeinanderfolgende isostatische Verdichtungsschritte mit einem dazwischenliegenden Glühprozeß oder durch Kombination erst eines Extrudiervorganges und zwei nachfolgenden isostatischen Verdichtungsschritten mit einem dazwischenliegenden Glühprozeß.

Weitere wesentliche Nachteile der hochtemperatursupraleitenden Formkörper des Standes der Technik sind, daß die im Naßmatrizenverfahren gepreßten Formkörper keine ausreichende Formgenauigkeit aufweisen, daß diese Formgebung besonders aufwendig ist und daß das Verfahren nicht automatisiert werden kann.

Verkaufsfähige geformte Vorprodukte für die weitere Verarbeitung zu massiven hochtemperatursupraleitenden Bauteilen wie z.B. Stromzuführungen bzw. zu hochtemperatursupraleitendem Band oder Draht müssen daher Eigenschaften aufweisen, die beim Anwender durch vergleichsweise wenige oder/und kurze energiesparende thermische oder/und mechanische Behandlungen in das Produkt überführt werden können. Ziel der Optimierung dieser Vorprodukte muß es außerdem sein, daß der gesamte Herstellungsprozeß bis zur Fertigstellung der Produkte möglichst einfach und kostengünstig ausgeführt wird, wobei auch bessere Produkteigenschaften erzielt werden sollen.

Der Erfindung lag die Aufgabe zugrunde, ein Verfahren zur Herstellung eines supraleitenden Materials bereitzustellen, mit dem eine bessere Textur auf einfache Weise erzeugt werden kann, so daß die hiermit herstellbaren geglühten Formkörper ärmer an die elektrischen Eigenschaften beeinträchtigenden Defekten sind sowie eine homogene Verdichtung, eine hohe Dichte und eine höhere Stromtragfähigkeit aufweisen. Eine weitere Aufgabe war es, ein wirtschaftlich arbeitendes Verfahren vorzuschlagen, das für einen industriellen Prozeß einsetzbar ist. Insbesondere sollen Vorprodukte in der Form von ungeglühten oder geglühten Formkörpern so vorbereitet werden, daß ihre nachfolgende Weiterverarbeitung zu massiven hochtemperatursupraleitenden Bauteilen wie z. B. Stromzuführungen bzw. zu hochtemperatursupraleitenden Bändern und Drähten im Vergleich zum Stand der Technik besonders einfach, schnell und energiesparend erfolgen kann.

Die Aufgabe wird gelöst mit einem Verfahren zur Herstellung eines Formkörpers, bei dem ein Gemisch oxidischer Ausgangspulver oder ein supraleitendes Material, das mindestens 30 Vol.-% plättchenförmiger Primärteilchen enthält und das so zusammengesetzt ist, daß bei späterer geeigneter thermischer Behandlung ein hochtemperatursupraleitendes Material gebildet wird, derart durch Mahlen, Scheren oder/und Walzen zerkleinert wird, daß das zerkleinerte Pulver eine Pulverkorngrößenverteilung mit einem d₉₀-Wert ≤ 20 µm aufweist, und bei dem die derart zerkleinerten Pulver mit dem Trockenmatrizenverfahren isostatisch verdichtet werden.

Unter dem Begriff Formkörper wird im Sinne dieser Erfindung ein geformter Körper verstanden, der erfindungsgemäß verdichtet und der gegebenenfalls durch weitere Prozeßschritte wie z.B. Glühen behandelt worden sein kann. Dieser Formkörper kann daher im wesentlichen aus einem Gemisch oxidischer Ausgangspulver, aus einem supraleitenden Material oder aus einem geglühten hochtemperatursupraleitenden Material bestehen. Der Begriff Formkörper wird daher in verschiedenen Stadien des Herstellungsganges beibehalten.

Als Ausgangsmaterial kommen ein Gemisch oxidischer Ausgangspulver oder ein supraleitendes Material in Frage. Falls von organischen Salzen wie z.B. einem Gemisch mehrerer Oxalate oder falls von einem Gemisch anorganischer Verbindungen wie z.B. Karbonaten oder/und Sulfaten ausgegangen wird, ist es erforderlich, diese zuerst vor der Verwendung für das erfindungsgemäße Verfahren zu kalzinieren, da beim Kalzinieren sehr große Gasmengen freigesetzt werden, die einen Preßkörper beim Erhitzen zerstören könnten. Beim Kalzinieren derartiger Ausgangsmaterialien - üblicherweise bei Temperaturen im Bereich von 150 bis 700°C - werden die nichtoxidischen Verbindungen zu Einzeloxiden oder/und Mehrfachoxiden umgesetzt. Andererseits kann auch bereits von einem supraleitenden Material ausgegangen werden, das durch Glühen, Erschmelzen oder/und Zerkleinern hergestellt worden sein kann und oft noch keinen oder keinen hohen Anteil an hochtemperatursupraleitenden Phasen aufweist.

Bereits beim Kalzinieren können u.U. erste tief- oder/und hochtemperatursupraleitende Phasen entstehen wie z.B. die tieftemperatursupraleitende Einschichterphase Bi₂Sr₂Cu₁Oₓ. In der Regel bildet sich aus dieser Einschichterphase die hochtemperatursupraleitende Zweischichterphase Bi₂Sr₂Ca₁Cu₂O_{x'} erst bei höher temperiertem oder/und etwas längerem Glühen - z.B. im Temperaturbereich von 700 bis 830°C. Schließlich entsteht bei deutlich längerem Glühen die hochtemperatursupraleitende Dreischichterphase Bi₂Sr₂Ca₂Cu₃O_{x"}, die erst über lange Glühzeiten von meist mehr als 50 h oder sogar mehr als 100 h im Temperaturbereich von meistens 820 bis 850 °C in ein hochstromtragfähiges, gut kristallisiertes, nahezu phasenreines Material überführt werden kann. Neben diesen supraleitenden Phasen erscheinen meistens mehrere nichtsupraleitende Phasen wie z.B. Erdalkalimetallcuprate und Kupferoxid. Die hier angedeutete Phasenabfolge ist jedoch komplizierter und sehr von der Zusammensetzung und ihrer Veränderung während des Prozesses sowie von den Prozeßparametern abhängig. Bezüglich des Glühens der Pulver und Formkörper sowie des wiederholten Glühens und des gesamten Temperaturablaufs sowie der weiteren Prozeßschritte wie z.B. Zerkleinern des supraleitenden Materials oder/und Walzen des Multifilaments bestehen vielfältige Variationsmöglichkeiten. Ziel des Prozeßablaufes muß es sein, einen möglichst hohen Anteil an hochtemperatursupraleitenden Phasen zu erreichen, möglichst eine Phasenreinheit ≥ 90 Vol.-%, vorzugsweise ≥ 95 Vol.-% oder besonders bevorzugt nahe bei 100 Vol.-% an hochtemperatursupraleitenden Phasen. Ein weiteres Ziel des Verfahrens muß es sein, die Textur, die Kornstruktur und die einzelnen Körner so auszubilden, daß eine möglichst hohe Stromtragfähigkeit erreicht wird.

Das Ausgangspulvergemisch bzw. das supraleitende Material, das erfindungsgemäß eingesetzt wird, muß so zusammengesetzt sein, daß bei späterer geeigneter thermischer Behandlung ein hochtemperatursupraleitendes Material gebildet wird. Die Ausbildung dieses geglühten hochtemperatursupraleitenden Materials kann durch einen oder mehrere Glühschritte bevorzugt am Ende der Bauteilherstellung von massiven Komponenten wie z.B. Stromzuführungen oder durch einen oder mehrere Glühschritte in Verbindung z.B. mit dem Walzen des in ein oder mehrere metallische Rohre gefüllten Formkörpers bevorzugt am Ende der Drahtherstellung nach der OPIT-Methode erfolgen. Die Ausgangspulver und die supraleitenden Materialien, die für das erfindungsgemäße Verfahren eingesetzt werden können, sind grundsätzlich bekannt. Bevorzugt sind solche, die - ggbfs. im Gemisch - eine mittlere Partikelgröße im Bereich von 1 bis 20 µm, insbesondere von 1,5 bis 15 µm, besonders bevorzugt von 2 bis 10 µm aufweisen, nach Uitraschallvordispergierung gemessen mit einem Lasergranulometer Master Sizer der Firma Malvern Instruments. Die Ausgangspulver und die supraleitenden Materialien sind vorteilhafterweise von hoher Reinheit, wobei die Summe der metallischen Verunreinigungen ≤ 1000 ppm ist, besonders bevorzugt ≤ 500 ppm. Vorzugsweise ist ihr Kohlenstoffgehalt ≤ 500 ppm, insbesondere ≤ 300 ppm, da damit eine Blasenbildung z.B. in einem Draht vermieden wird. Blasen beeinträchtigen die Stromtragfähigkeit sowie die mechanischen Eigenschaften des Drahtes stark.

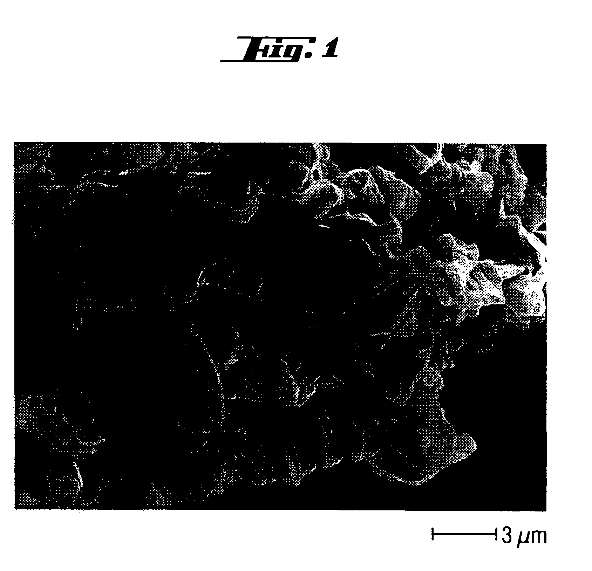

Das Ausgangspulvergemisch oder das supraleitende Material, das zu Beginn des erfindungsgemäßen Verfahrens eingesetzt wird, soll mindestens 30 Vol.%, insbesondere mindestens 50 Vol.-%, besonders bevorzugt mindestens 70 Vol.-% plättchenförmige Primärteilchen enthalten. Als Primärteilchen werden die bei geeigneter Zerkleinerung erzielbaren kleinsten Einzelteilchen, z.B. plättchenförmige Teilchen, bezeichnet. Es wurde bei ersten Versuchen beobachtet, daß der Anteil der hochtemperatursupraleitenden Phase(n) in der Regel höher ist, je höher der Gehalt an plättchenförmigen Primärteilchen ist. Üblicherweise enthalten die Ausgangspulvergemische und die ggbfs. speziell zerkleinerten supraleitenden Materialien einen hohen Anteil Partikel aus angesinterten, harten Aggregaten neben relativ leicht trennbaren Agglomeraten. Die Aggregate und Agglomerate bestehen oft im wesentlichen aus plättchenförmigen Primärteilchen, die bei den Aggregaten stark gebunden und bei den Agglomeraten vergleichsweise schwach gebunden sind (Figur 1). Der Anteil der Partikel in der Form der vereinzelt vorliegenden plättchenförmigen Primärteilchen ist in der Regel gering.

Beim Zerkleinern der Partikel auf eine Pulverkorngrößenverteilung mit einem d₉₀-Wert ≤ 20 µm werden die Aggregate weitgehend zerstört, die Agglomerate weitestgehend zerteilt, und bei außerordentlich hartem Angriff werden auch vermehrt plättchenförmige Primärteilchen zerschlagen. Das Ausgangspulvergemisch oder/und das supraleitende Material wird vorteilhafterweise derart zerkleinert, daß höchstens 90 Vol.-%, insbesondere höchstens 70 Vol.-%, noch weiter bevorzugt höchstens 50 Vol.-%, besonders bevorzugt aber mindestens 10 Vol.-%, noch weiter bevorzugt mindestens 25 Vol.-% der Pulverpartikel zur Formgebung in Plättchenform vorliegen. Beim Zerkleinern werden die Pulver vorzugsweise bis auf eine Agglomeratkorngröße heruntergemahlen, bei der keine oder nahezu keine unzerstörten, harten Aggregate > 15 µm und möglichst auch keine oder nahezu keine vergleichsweise leicht zerstörbaren Agglomerate > 25 µm mehr auftreten. Die optimale erfindungsgemäße Zerkleinerung besteht in der Vereinzelung der Primärteilchen beim Zerteilen der Aggregate und Agglomerate, ohne daß die plättchenförmigen Primärteilchen stark aufgemahlen werden. Die Anteile der im Rasterelektronenmikroskop erkennbaren plättchenförmigen Primärteilchen nehmen beim Mahlen, Scheren oder/und Walzen oft deutlich ab. Wenn andererseits das Ausgangspulvergemisch oder das supraleitende Material vor oder/und nach der Zerkleinerung thermisch behandelt wird, erhöht sich der Anteil plättchenförmiger Primärteilchen in der Regel, z.B. beim Glühen bei etwa 600 bis 800 °C über vorzugsweise 2 bis 10 Stunden in Sauerstoff-haltiger Atmosphäre, auf mindestens 40 Vol.-%, insbesondere auf mindestens 60 Vol.-%, vor allem auf mindestens 75 Vol.-%.

Insbesondere bei einer zu starken Zerschlagung der plättchenförmigen Primärteilchen beim Zerkleinern empfiehlt sich diese Glühbehandlung, um im Rahmen eines Kristallwachstums wieder die Plättchenform der Primärteilchen auszubilden. Falls diese Glühbehandlung jedoch zu stark wirken sollte und zu etwas stärker versinterten Pulvern führen sollte, ist jedoch eine leichte Aufmahlung z.B. in einer Vibrationsmühle über etwa 15 Minuten notwendig. Es empfiehlt sich die Kontrolle dieses Prozesses über rasterelektronenmikroskopische Untersuchungen.

Die Zerkleinerung des Ausgangspulvergemisches oder des supraleitenden Materials durch Mahlen, Scheren oder/und Walzen erfolgt vorzugsweise mit einer Vibrationsmühle, einer Strahlmühle oder/und einem Scherwalzwerk. Hierbei ist eine Trockenmahlung mit einem Gehalt an organischen Flüssigkeiten von bis zu 0,5 Gew.-% einer Naßmahlung in organischen Lösungsmitteln vorzuziehen. Dem Ausgangspulvergemisch oder dem supraleitenden Material werden vorzugsweise nur organische Mahlhilfsstoffe zugegeben. Diese Hilfsstoffe können einerseits als Mahlhilfsmittel bei der Zerkleinerung hilfreich sein, andererseits aber der Erzeugung rieselfähiger Granulate oder/und gut preßbarer Formkörper dienen. Bei der Verwendung polymerer Flüssigkeiten wie z.B. Tensiden werden bevorzugt Mengen bis zu 0,5 Gew.-% zugesetzt.

Die Vibrationsmahlung dauert vorzugsweise 20 bis 80 Minuten, insbesondere 30 bis 60 Minuten, bei einer Amplitude von vorzugsweise 3 bis 6 mm, insbesondere 4 bis 5 mm, bei Verwendung von Mahlkörpern z.B. aus Zirkonoxidkeramik und eines Mahlkörperfüllungsgrades von 40 bis 80 %, vorzugsweise von 55 bis 65 % und einer Mahlgutmenge, die vorzugsweise etwa dem Lückenvolumen zwischen den Mahlkörpern entspricht.

Die Strahlmahlung kann in einer Spiralstrahlmühle mit einer Pulverdosiermenge von z.B. 500 g/h in einem Mühlendurchlauf erfolgen. Das Scherwalzen eignet sich besonders gut zum Entschichten feiner, aus plättchenförmigen Primärteilchen bestehenden oder gut spaltenden Partikel.

Mit den bevorzugten Zerkleinerungsaggregaten läßt sich bei Verwendung von mit Kunststoff ausgekleideten Mahlbehältern und durch die Bildung einer Mahlgutoberflächenschicht auf den Mahlkörpern eine Verunreinigung des Mahlproduktes durch Mahlkugelabrieb weitgehend vermeiden. Durch Mahlung in inerter Atmosphäre wie z.B. technischem Stickstoff kann die Erhöhung des Kohlenstoffgehaltes des Mahlgutes bei einer Vibrationsmahlung um Beträge von etwa 50 ppm, bei einer Strahlmühle um Beträge von 50 bis 100 ppm begrenzt werden. Tenside als Mahlhilfsmittel können überraschenderweise zur Ausbildung eines rieselfähigen Granulats beitragen, ohne eine Sprühgranuliertechnik oder eine andere Granuliertechnik anwenden zu müssen. Rieselfähige Granulate sind für die automatische Befüllung zu bevorzugen, aber Gehalte an polymeren Flüssigkeiten oder/und an sonstigen organischen Hilfsstoffen sind vorzugsweise sofort nach dem Pressen oder bis zur Einbringung des gepreßten Formkörpers in ein Rohr zu entfernen. Spätestens bis zum Einbringen eines Formkörpers in ein Metallrohr, vorzugsweise gleich nach dem Pressen, sollten die organischen Hilfsstoffe durch Ausheizen, Ausbrennen oder chemische Desorption entfernt werden.

Die Formkörper sind bevorzugt von im wesentlichen länglicher, zylindrischer, prismatischer oder rohrförmiger Geometrie, können aber auch von im wesentlichen isometrischer, ringförmiger, scheibenförmiger oder andersartiger Geometrie sein. Die gepreßten Formkörper können Vollkörper oder Hohlkörper sein. Es ist bevorzugt, daß das Verhältnis von Länge zu Wanddicke des Formkörpers zum Zeitpunkt der Formgebung mindestens 2:1, vorzugsweise mindestens 4:1, besonders bevorzugt mindestens 6:1, ganz besonders bevorzugt mindestens 8:1 ist. Die Länge der aus den gepreßten Formkörpern gefertigten erfindungsgemäß weiter verarbeiteten Formkörper und der daraus hergestellten Endprodukte kann z.B. durch Teilen für mehrere einzelne Bauteile oder durch Abarbeiten von Enden verringert sein, so daß auch das Verhältnis von Länge zu Wanddicke, das bei der Formgebung vorzugsweise eingehalten wird, nicht bezüglich der Bauteilgeometrie beibehalten werden muß. Die Formkörper sind insbesondere Vorprodukte, um hieraus Drähte, Bänder, Stäbe, Rohre bzw. Hohl- oder Vollkörper zu fertigen, die insbesondere zur Herstellung von und Verwendung als Starkstromkabel, Transformatoren, Wicklungen, Magneten, magnetischen Lagern oder Stromzuführungen eingesetzt werden können. Es ist empfehlenswert, die Formkörper dahingehend zu optimieren, daß sie in einem vergleichsweise einfachen anschließenden Herstellungsprozeß zu den gewünschten hochtemperatursupraleitenden Komponenten verarbeitet werden können. Hierzu gehören insbesondere ein oder mehrere Glühbrände, in denen die bereits vorher texturierten Pulverpartikel beim Sintern eine starke Textur behalten.

Vorteilhafterweise wird beim isostatischen Pressen nach dem Trockenmatrizenverfahren ein Preßdruck von 400 bis 5000 bar, insbesondere von 1500 bis 3000 bar, besonders bevorzugt von 1800 bis 2500 bar eingesetzt, um die Verdichtung und Texturierung des Pulvers zu bewirken. Bei ausreichender Rieselfähigkeit des zerkleinerten Pulvers, insbesondere eines Granulats, kann mit automatischer Pulverdosierung, automatischem Preßzyklus und automatischer Preßlingsentnahme gearbeitet werden, so daß ein Formkörper oder bei einem Mehrfachwerkzeug auch eine entsprechend höhere Zahl an Formkörpern in kürzester Zeit (ca. 2 Minuten Zykluszeit) erhalten wird, was etwa einem Zehntel der Zeit des Naßmatrizenverfahrens entspricht.

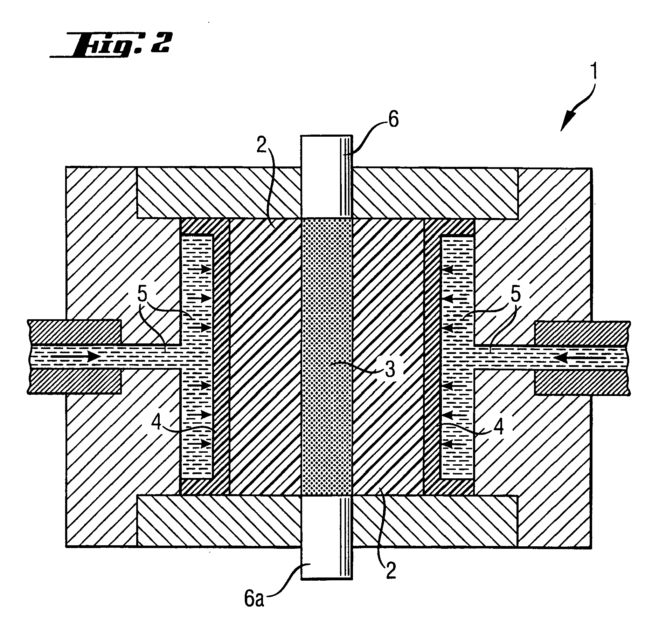

Figur 2 zeigt beispielhaft ein Schema eines Werkzeugblocks (1) einer Isostatischen Presse nach dem Trockenmatrizenverfahren mit Matrize (2) und eingefülltem Preßgut (3). Die Preßform (4) ist beim Trockenmatrizenverfahren in der Regel deutlich dickwandiger als beim Naßmatrizenverfahren und weist eine höhere Härte, z.B. Shore A im Bereich von 80 bis 90, auf. Beispielsweise kann eine ca. 30 mm dicke Polyurethan-Matrize verwendet werden, die sich durch hohe Formstabilität im drucklosen Zustand, gute Elastizität bei Druckbeaufschlagung, gute Rückstelleigenschaften bei Druckabbau und gute Formstabilität im Langzeitbetrieb auszeichnet. Dadurch wird eine bessere Maßhaltigkeit und Formtreue erreicht. Die Matrize (2) ist in einem Werkzeugblock (1) eingesetzt und wird über eine elastische Trennmembrane (4) mittels eines Druckübertragungsmediums (5) z.B. auf Basis Wasser nur radial mit hydrostatischem Druck beaufschlagt. Die Konstruktion der Presse verhindert nahezu vollständig nicht-radiale Preßkraftanteile, da die Schließstempel (6, 6a) selbst praktisch keine Kraft übertragen, sondern dem von innen nach außen wirkenden Kraftanteil entgegenwirken. Das wirkt sich auf die gepreßten Formkörper derart aus, daß die gewünschte Textur eingebracht wird. Aufgrund der Konstruktion der Presse und der Eigenschaften der Matrize können enge Form- und Lagetoleranzen eingehalten werden. Der gesamte Ablauf des Befüllens, Verschließens, des Druckauf- und abbauens, Öffnens und Entformens des Formkörpers kann vollautomatisch erfolgen.

Beim Pressen von Hohlkörpern kann z.B. ein Metallkern vorzugsweise zentrisch im Matrizenhohlraum angeordnet werden. Der auf den Kern aufgepreßte Formkörper kann bei geeigneter Massebeschaffenheit aufgrund der Rückdehnung des oxidischen Materials oder/und bei konischen Kernen leicht entformt werden.

Die gewünschte Textur tritt ein, wenn keine oder nahezu keine unzerstörten harten Aggregate > 15 µm im Preßgut enthalten sind. Die Agglomerate sind in der Regel beim Pressen zerkleinert worden, können aber ggbfs. noch bei einer nachfolgenden mechanischen Weiterverarbeitung weiter zerteilt werden. Die Textur wirkt sich beispielsweise bei geeigneten Pulvern auf Basis (Bi,Pb)-(Sr,Ca)-Cu-O dahingehend aus, daß die Textur vom Rand zur Mitte von z. B. 10 mm dicken Formkörpern unter dem Rasterelektronenmikroskop keine signifikante Änderung erfährt und in axialer Richtung des Formkörpers vergleichsweise stark ausgerichtet ist. Ein Glühen wirkt sich auf die Textur der Formkörper nicht negativ aus.

Überraschenderweise wurde gefunden, daß durch die Kombination einer Zerkleinerung, bei der die harten Aggregate weitgehend zerstört und die plättchenförmigen Primärteilchen nicht sehr stark zerschlagen werden, mit einer isostatischen Formgebung nach dem Trockenmatrizenverfahren unter Anwendung einer nahezu vollständig radialen Kraftübertragung gut vortexturierte Formkörper hergestellt werden können, die den Aufwand der weiteren Verarbeitung, insbesondere der weiteren mechanischen Bearbeitung oder/und des langen Glühens, wesentlich verringern.

Insbesondere bei der Herstellung supraleitender Bänder und Drähte wird vorzugsweise mindestens ein länglicher metallischer Körper bei der Formgebung in den Formkörper eingebettet. Der oder jeder längliche metallische Körper kann als Seele in Längsrichtung im Bereich der Längsachse oder um die Längsachse des Formkörpers eingebettet werden. Der längliche metallische Körper kann u.a. ein Stab, Draht oder Filament sein und kann im Produkt durch Grenzschichteffekte Supraleiterkeramik/Metall zu einer höheren Stromdichte beitragen. Insbesondere bei der Herstellung supraleitender Bänder und Drähte wird vorzugsweise der oder jeder Formkörper in ein Rohr von im wesentlichen zylindrischer oder prismatischer Form eingeführt, insbesondere in ein einseitig geschlossenes, bevorzugt metallisches Rohr. Der oder jeder längliche Körper oder/und das Rohr besteht im wesentlichen aus mindestens einem Metall oder mindestens einer Legierung und enthält vorzugsweise Silber.

Der Formkörper besitzt ein gutes Verformungsverhalten bei der Herstellung von Mono- und Multifilament-Bändern bzw. -Drähten nach der Pulver-im-Rohr-Methode zur Herstellung von hochstromtragenden Leitern für die Elektrotechnik. Das Vorprodukt kann nach dem Pressen des Formkörpers oder nach einem Glühen des gepreßten Formkörpers fertiggestellt sein. Das Vorprodukt kann durch einmaliges oder mehrfaches Extrudieren oder/und Walzen zu einem Monofilament und gegebenenfalls durch Bündeln von mehreren Monofilamenten und evtl. zusätzlich durch einmaliges oder mehrfaches Extrudieren oder/und Walzen zu einem Multifilament weiterverarbeitet werden. Insbesondere bei der Herstellung supraleitender Bänder und Drähte wird der Formkörper, das mit Formkörper(n) gefüllte Rohr oder der weiterverarbeitete Formkörper mehrfach abwechselnd geglüht und gewalzt. Diese Verfahrensschritte sind grundsätzlich bekannt. Dabei soll eine noch bessere Textur des z.B. in einer Silberumhüllung befindlichen Vorproduktes erreicht werden. Vorteilhafterweise werden zwischen den letzten Walzschritten noch Glühungen ausgeführt, die z.B. bei Materialien auf Basis (Bi,Pb)-(Sr,Ca)-Cu-O ohne oder mit Bleigehalt die möglichst vollständige Ausbildung der supraleitenden Phase BSCCO 2223 und die Ausheilung der beim Extrudieren/Walzen eingebrachten Strukturdefekte der plättchenförmigen Primärteilchen bewirken sollen. Die Verdichtung, der Texturierungsgrad, der Störstellengrad sowie die Phasenzusammensetzung und Verteilung der supraleitenden Phase(n) sind entscheidende Einflußfaktoren auf die Stromtragfähigkeit der supraleitenden Materialien und auf die zu leitenden Ströme der Bauteile. Die auf diese Weise hergestellten Bänder und Drähte weisen einen erheblich höheren Anteil an hochtemperatursupraleitendem Material in Bezug auf den Anteil an Metall(en) auf. Der sog. Hüllfaktor als Verhältnis des Anteils an Keramik zum Gesamtquerschnitt des Bandes oder Drahtes ist damit ebenso wie die Stromtragfähigkeit erheblich erhöht.

Es ist erforderlich, daß der Formkörper, das mit Formkörper(n) gefüllte Rohr oder der weiterverarbeitete Formkörper bei Temperaturen von 400 bis 900 °C, insbesondere bei 500 bis 850 °C, bei Materialien auf Basis (Y,SE)-Ea-Cu-O sogar im Bereich von 400 bis 1100 °C, vorzugsweise von 600 bis 1050 °C, geglüht wird. Ea bezeichnet hierbei Erdalkalielemente. Bei Angaben zur Substitution von Elementen müssen nicht immer alle Arten der in Klammern aufgeführten Elemente anwesend sein. Zur Herstellung von massiven Bauteilen auf Basis (Bi,Pb)-Ea-Cu-O ist eine Glühung bei z.B. 800 bis 850 °C über 10 bis 150 h, vorzugsweise über 20 bis 100 h, insbesondere über 30 bis 60 h, in einer Sauerstoff-haltigen Atmosphäre nötig. Es empfiehlt sich, daß die Atmosphäre im wesentlichen aus einem Gemisch aus Stickstoff und Sauerstoff mit Sauerstoffanteilen von 0,1 bis 50 Vol.-%, insbesondere von 1 bis 30 Vol.-%, besonders bevorzugt von 10 bis 25 Vol.-% besteht. Vorzugsweise wird im Gasstrom gearbeitet. Der geglühte Formkörper kann durch mindestens eine Nachglühung behandelt werden.

Das Supraleitermaterial oder das geglühte hochtemperatursupraleitende Material enthält mindestens eine der supraleitenden Phasen mit einer Zusammensetzung im wesentlichen auf der Basis (Bi,Pb)-Ea-Cu-O, (Y,SE)-Ea-Cu-O oder (TI,Pb)-(Ea,Y)-Cu-O, wobei Ea für Erdalkalielemente und insbesondere für Ba, Ca oder/und Sr steht. Hierbei weisen die auftretenden Phasen insbesondere eine Zusammensetzung auf von annähernd (Bi,Pb)₂(Sr,Ca)₂Cu₁O_{x'}, (Bi,Pb)₂(Sr,Ca)₃Cu₂O_{x"}, (Bi,Pb)₂(Sr,Ca)₄Cu₃O_{x'''}, (Y,SE)₁Ba₂Cu₃O_{y'}, (Y,SE)₂Ba₁Cu₁O_{y"}, (Ti,Pb)₂(Ba,Ca)₂Cu₁O_{z'}, (TI,Pb)₂(Ca,Ba)₃Cu₂O_{z"}, (TI,Pb)₂(Ca,Ba)₄Cu₃O_{z'''}, (TI,Pb)₁(Ca,Ba)₃Cu₂O_{z''''}, (TI,Pb)₁(Ca,Ba)₄Cu₃O_{z'''''}. In manchen Fällen empfiehlt es sich, dem Ausgangspulvergemisch, dem Supraleitermaterial oder dem geglühten hochtemperatursupraleitenden Material einen Zusatz an Sulfat(en) zuzumischen, so daß neben der oder den supraleitenden Phasen ein Gehalt an Erdalkalisulfaten, insbesondere an BaSO₄, SrSO₄ oder/und (Ba,Sr)SO₄ auftritt.

Der erfindungsgemäße supraleitende Formkörper ist bei einem nur mäßigen Glühen dadurch gekennzeichnet, daß seine vorrangig plättchenförmigen Primärteilchen im Vergleich zu denen des gepreßten Formkörpers gewachsen und teilweise zusammengesintert sind und zumindest in einem Teil der Außenwand im wesentlichen senkrecht zur Preßrichtung des isostatischen Verdichtens ausgerichtet sind.

Der erfindungsgemäße supraleitende Formkörper ist bei einem starken Glühen dadurch gekennzeichnet, daß sein Korngefüge stark versintert ist und zumindest in einem Teil der Außenwand im wesentlichen senkrecht zur Preßrichtung des isostatischen Verdichtens ausgerichtet ist.

Der erfindungsgemäße Formkörper kann als Vorprodukt vorzugsweise für die Herstellung von hochtemperatursupraleitenden Drähten, Bändern, Stäben, Rohren, Hohl- oder Vollkörper, insbesondere zur Herstellung von Starkstromkabeln, Transformatoren, Wicklungen, Magneten, magnetischen Lagern oder Stromzuführungen verwendet werden.

### Figuren

Figur 1 zeigt eine rasterelektronenmikroskopische Aufnahme eines oxidischen Ausgangspulvers auf Basis (Bi,Pb)-Ea-Cu-O vor der Mahlung entsprechend Anspruch 1.
Figur 2 gibt ein Schema eines Werkzeugblocks einer Isostatischen Presse nach dem Trockenmatrizenverfahren mit Matrize und eingefülltem Preßgut wieder.

### Beispiele

Die Erfindung soll beispielhaft anhand des folgenden Vergleichsbeispiels und der erfindungsgemäßen Beispiele dargestellt werden:

### Vergleichsbeispiel 1:

Ein Pulver der Zusammensetzung Bi_{1,7}Pb_{0,33}Sr_{1,88}Ca_{1,96}Cu₃Oₓ wurde ohne Zerkleinerung in mehreren Glühschritten insgesamt 20 h bei 790 °C bis zur Umsetzung in das Zweischichtmaterial synthetisiert, wobei neben der hochtemperatursupraleitenden Phase BSCCO 2212 noch gewisse Gehalte an Kupferoxid und Erdalkalimetallcupraten vorlagen. Das so erhaltene Material wies einen Kohlenstoffgehalt von 200 ppm und einen Stickstoffgehalt von 100 ppm auf. Die plättchenförmigen Primärteilchen besaßen vorrangig eine Dicke von 0,3 bis 0,5 µm und eine Länge von 1 bis 8 µm, wie an Bruchflächen unter dem Rasterelektronenmikroskop ermittelt wurde. Die mittlere Größe der Partikel, die vor allem in Form von Agglomeraten und Aggregaten vorlagen, betrug etwa 20 µm; sie verringerte sich durch fünfzehnminütige Anwendung von Ultraschall eines Ultraschallfingers bei der Vorbereitung der Suspension für die Bestimmung der Partikelgrößenverteilung mittels des Lasergranulometers Master Sizer XSB.OD der Firma Malvern Instruments auf 13 µm. Das Pulver wurde, ohne daß nach dem Glühen eine Zerkleinerung oder eine Granulierung vorgenommen wurde, im Naßmatrizenverfahren isostatisch bei 2500 bar zu Zylindern von 12 ± 2 mm Durchmesser und von 110 mm Länge gepreßt. Die Formabweichung der Preßlinge für die weitere Verarbeitung war so groß, daß der Formkörper erst nach einer mechanischen Bearbeitung durch Drehen in ein Silberhüllrohr eingeführt werden konnte und die erforderliche Paßgenauigkeit von maximal ± 0,2 mm Durchmesserschwankung aufwies. Die Dichte der Preßlinge betrug 4,3 g/cm³, was einer Relativen Dichte von etwa 68 % entspricht. Die unzerstörten, harten Aggregate sind auch nach dem Pressen mittels Rasterelektronenmikroskop zu erkennen. Es erfolgte keine unter dem Rasterelektronenmikroskop sichtbare merkliche Ausrichtung der Partikel. Die Partikel waren daher nicht wesentlich in Richtung des zukünftigen Stromflusses orientiert.

### Beispiel 1:

Es wurde das Ausgangspulver von Vergleichsbeispiel 1 eingesetzt und in einer Vibrationsmühle vom Typ M18 der Firma SWECO Europe 60 min trocken bis zu einer mittleren Partikelgröße von 4 µm gemahlen. Die Partikelgrößenverteilung wurde wie in allen erfindungsgemäßen Beispielen ohne Ultraschallbehandlung mit dem Lasergranulometer bestimmt. Das Mahlgut wurde isostatisch nach einem Trockenmatrizenverfahren in einem Werkzeug entsprechend Figur 1 bei 2000 bar zu Formkörpern mit den Abmessungen von 12 ± 0,2 mm Durchmesser und von 110 mm Länge unter den sonst gleichen Bedingungen wie im Vergleichsbeispiel verpreßt. Die Durchmessertoleranz ± 0,2 mm konnte mühelos bei einer großen Zahl an Proben eingehalten werden. Die Gründichte betrug 4,5 g/cm³, was einer Relativen Dichte von etwa 71 % entspricht. Mit dem Rasterelektronenmikroskop waren an Bruchflächen der gepreßten Formkörper (= Vorprodukte) keine Aggregate mehr erkennbar. Die Plättchentextur in axialer Richtung war stark ausgeprägt.

### Beispiel 2:

Es wurde das Ausgangspulver von Vergleichsbeispiel 1 eingesetzt und in einer Laborstrahlanlage vom Typ MC100KXBD der Firma Crispo AG mit einem Durchsatz von 500 g/h bei einem Mühlendurchlauf auf eine mittlere Partikelgröße von 2,5 µm trocken gemahlen. Das Mahlgut wurde isostatisch nach dem Trockenmatrizenverfahren zu Formkörpern unter den gleichen Bedingungen und mit den gleichen Abmessungen wie im Beispiel 1 gepreßt. Ihre Gründichte betrug 4,45 g/cm³, was einer Relativen Dichte von etwa 70 % entspricht. Unter dem Rasterelektronenmikroskop waren an Bruchflächen von gepreßten Formkörpern keine Aggregate mehr erkennbar. Die Plättchentextur in axialer Richtung war deutlich ausgeprägt.

### Beispiel 3:

Ein Pulvergemisch der Zusammensetzung Bi_{1,9}Sr_{2,11}Ca_{0,9}Cu₂O_{y} wurde bei einer Temperatur von etwa 1000 °C homogen aufgeschmolzen. Die Schmelze wurde abgegossen. Der auf Raumtemperatur abgekühlte Schmelzregulus wurde grob zerkleinert. Dieses Pulver wurde durch Mahlung in einer Mahl- und Sichtanlage vom Typ 100AFG der Hosokawa-Alpine AG auf eine mittlere Partikelgröße von 3 µm trocken heruntergemahlen, zur weiteren Verringerung des Kohlenstoffgehalts, der bei der Mahlung erhöht wurde, zwischengeglüht und mit dem Trockenmatrizenverfahren isostatisch bei 2000 bar zu prismatischen Formkörpern 9^{-0,2} mm x 9^{-0,2} mm und einer Länge von 100 mm gepreßt. Die Dichte betrug 4,7 g/cm³, was einer Relativen Dichte von etwa 71 % entspricht. Mit dem Rasterelektronenmikroskop wurde eine hervorragende Textur in axialer Richtung nachgewiesen.

### Beispiel 4:

Es wurde unter den gleichen Bedingungen wie beim Beispiel 1 gearbeitet, außer daß dem Ausgangspulver 0,01 % einer organischen Flüssigkeit in Form einer Lösungsmittel-freien Säure zugegeben wurde. Es ergaben sich die gleichen Ergebnisse wie beim Beispiel 1, wobei jedoch das gemahlene Pulver rieselfähig granuliert war, so daß es gut geeignet war, um beim Pressen automatisch eingefüllt, dosiert und gepreßt zu werden.

## Patentansprüche

1. Verfahren zur Herstellung eines Formkörpers, bei dem ein Gemisch oxidischer Ausgangspulver oder ein supraleitendes Material, das mindestens 30 Vol.-% plättchenförmiger Primärteilchen enthält und das so zusammengesetzt ist, daß bei späterer geeigneter thermischer Behandlung ein hochtemperatursupraleitendes Material gebildet wird, derart durch Mahlen, Scheren oder/und Walzen zerkleinert wird, daß das zerkleinerte Pulver eine Pulverkorngrößenverteilung mit einem d₉₀-Wert ≤ 20 µm aufweist, und bei dem die derart zerkleinerten Pulver mit dem Trockenmatrizenverfahren isostatisch verdichtet werden.

2. Verfahren nach Anspruch 1, **dadurch gekennzeichnet, daß** das Ausgangspulvergemisch oder/und das supraleitende Material derart zerkleinert wird, daß höchstens 90 Vol.-% der Pulverpartikel zur Formgebung in Plättchenform vorliegen.

3. Verfahren nach Anspruch 1 oder 2, **dadurch gekennzeichnet, daß** das Ausgangspulvergemisch oder das supraleitende Material mit einer Vibrationsmühle, einer Strahlmühle oder/und einem Scherwalzwerk zerkleinert wird.

4. Verfahren nach einem der Ansprüche 1 bis 3, **dadurch gekennzeichnet, daß** das Ausgangspulvergemisch oder das supraleitende Material vor oder/und nach der Zerkleinerung thermisch so behandelt wird, daß der Anteil plättchenförmiger Primärteilchen auf mindestens 40 Vol.-%, insbesondere auf mindestens 60 Vol.%, vor allem auf mindestens 75 Vol.-% erhöht wird.

5. Verfahren nach einem der Ansprüche 1 bis 4, **dadurch gekennzeichnet, daß** dem Ausgangspulvergemisch oder dem supraleitenden Material organische Hilfsstoffe zugegeben werden und daß bei der Zerkleinerung im trockenen oder nahezu trockenen Zustand ein rieselfähiges Pulver erzeugt wird.

6. Verfahren nach einem der Ansprüche 1 bis 5, **dadurch gekennzeichnet, daß** das zerkleinerte Pulver zu im wesentlichen zylindrischen, prismatischen oder rohrförmigen Formkörpern geformt wird.

7. Verfahren nach einem der Ansprüche 1 bis 6, **dadurch gekennzeichnet, daß** die zerkleinerten Pulver zu länglichen Formkörpern mit einem Verhältnis von Länge zu Außendurchmesser bzw. der Länge zur größten Dicke von mindestens 2:1, insbesondere von mindestens 4:1, geformt werden.

8. Verfahren nach einem der Ansprüche 1 bis 7, **dadurch gekennzeichnet, daß** mindestens ein länglicher metallischer Körper bei der Formgebung in den Formkörper eingebettet wird.

9. Verfahren nach Anspruch 8, **dadurch gekennzeichnet, daß** der oder jeder längliche metallische Körper als Seele in Längsrichtung im Bereich der oder um die Längsachse des Formkörpers eingebettet wird.

10. Verfahren nach einem der Ansprüche 8 oder 9, **dadurch gekennzeichnet, daß** der oder jeder längliche Körper oder/und das Rohr im wesentlichen aus mindestens einem Metall oder mindestens einer Legierung besteht und vorzugsweise Silber enthält.

11. Verfahren nach einem der Ansprüche 1 bis 10, **dadurch gekennzeichnet, daß** ein Mehrfachwerkzeug zum isostatischen Verdichten verwendet wird.

12. Verfahren nach einem der Ansprüche 1 bis 11, **dadurch gekennzeichnet, daß** der oder jeder Formkörper in ein Rohr von im wesentlichen zylindrischer oder prismatischer Form eingeführt wird, insbesondere in ein einseitig geschlossenes, bevorzugt metallisches Rohr.

13. Verfahren nach einem der Ansprüche 1 bis 12, **dadurch gekennzeichnet, daß** organische Hilfsstoffe durch Ausheizen, Ausbrennen oder chemische Desorption entfernt werden.

14. Verfahren nach einem der Ansprüche 7 bis 13, **dadurch gekennzeichnet, daß** der Formkörper durch einmaliges oder mehrfaches Extrudieren oder/und Walzen zu einem Monofilament und ggbfs. durch Bündeln von mehreren Monofilamenten und evtl. zusätzlich durch einmaliges oder mehrfaches Extrudieren oder/und Walzen zu einem Multifilament weiterverarbeitet wird.

15. Verfahren nach einem der Ansprüche 1 bis 14, **dadurch gekennzeichnet, daß** der Formkörper, das mit Formkörper(n) gefüllte Rohr oder der weiterverarbeitete Formkörper bei Temperaturen von 400 bis 900 °C, bei Materialien auf Basis (Y,SE)-Ea-Cu-O sogar bis 1100 °C geglüht wird.

16. Verfahren nach einem der Ansprüche 1 bis 15, **dadurch gekennzeichnet, daß** der Formkörper, das mit Formkörper(n) gefüllte Rohr oder der weiterverarbeitete Formkörper durch mindestens eine thermische Zwischen- oder/und Nachbehandlung geglüht wird.

17. Verfahren nach einem der Ansprüche 1 bis 16, **dadurch gekennzeichnet, daß** der Formkörper, das mit Formkörper(n) gefüllte Rohr oder der weiterverarbeitete Formkörper mehrfach abwechselnd geglüht und gewalzt wird.

18. Verfahren nach einem der Ansprüche 1 bis 17, **dadurch gekennzeichnet, daß** das Supraleitermaterial oder das geglühte hochtemperatursupraleitende Material mindestens eine der supraleitenden Phasen mit einer Zusammensetzung im wesentlichen auf der Basis (Bi,Pb)-Ea-Cu-O, (Y,SE)-Ea-Cu-O oder (TI,Pb)-(Ea,Y)-Cu-O enthält, wobei Ea für Erdalkalielemente und insbesondere für Ba, Ca oder/und Sr steht.

19. Verfahren nach Anspruch 18, **dadurch gekennzeichnet, daß** dem Ausgangspuivergemisch, dem Supraleitermaterial oder dem geglühten hochtemperatursupraleitenden Material ein Zusatz an Sulfat(en) zugemischt wird, so daß neben der oder den supraleitenden Phasen ein Gehalt an Erdalkalisulfaten, insbesondere an BaSO₄, SrSO₄ oder/und (Ba,Sr)SO₄, auftritt.

## Claims

1. Method for the production of a shaped body, in which a mixture of oxidic base powder, or a supraconductor material, containing at least 30% by volume flake-shaped primary particles, with a composition which is such that it forms a high-temperature supraconductor material when later subjected to the appropriate thermal treatment, is reduced by means of milling, shearing, and/or rolling, in such a way that the resulting reduced powder has a particle size distribution with a d₉₀ value ≤ 20 µm, and wherein the such reduced powder is isostatically compacted using the dry mold process.

2. Method according to claim 1, **characterized in that** the base powder mixture, and/or the supraconductor material is reduced in such a way that 90% by volume of the powder particles for the shaping process is present in the form of flakes.

3. Method according to claims 1 or 2, **characterized in that** the base powder mixture, or the supraconductor material, is reduced using a vibrating mill, a jet mill, and/or a shear rolling mill.

4. Method according to one of the claims 1 to 3, **characterized in that** the base powder mixture, or the supraconductor material is thermally treated before, and/or after the reduction such that a portion of flake-shaped primary particles is increased to at least 40% by volume, particularly to at least 60% by volume, more particularly to 75% by volume.

5. Method according to one of the claims 1 to 4, **characterized in that** organic auxiliary materials are added to the base powder mixture, or to the supraconductor material, and that a free flowing powder is created with the reduction in a dry, or nearly dry state.

6. Method according to one of the claims 1 to 5, **characterized in that** the reduced powder is shaped into essentially cylindrical, prismatic, or tubular shaped bodies.

7. Method according to one of the claims 1 to 6, **characterized in that** the reduced powder is shaped into oblong shaped bodies with a ratio of length to outer diameter, or length to the largest thickness, of at least 2:1, particularly of at least 4:1.

8. Method according to one of the claims 1 to 7, **characterized in that** at least one oblong metallic body is embedded into the shaped body during the shaping process.

9. Method according to claim 8, **characterized in that** the oblong metallic body (bodies) is/are embedded as a core in longitudinal direction in the region of the longitudinal axis, or around the same, of the shaped body.

10. Method according to one of the claims 8 or 9, **characterized in that** the, or each, oblong body, and/or the tube, is essentially comprised of at least metal, or at least an alloy, and preferably contains silver.

11. Method according to one of the claims 1 to 10, **characterized in that** a manifold tool is used for the isostatic compacting.

12. Method according to one of the claims 1 to 11, **characterized in that** the, or each, shaped body is guided into a tube of essentially cylindrical or prismatic shape, particularly into a unilaterally closed, preferably metallic tube.

13. Method according to one of the claims 1 to 12, **characterized in that** organic auxiliary materials are removed by means of baking out, burning out, or chemical desorption.

14. Method according to one of the claims 7 to 13, **characterized in that** the shaped body is processed by means of singular or multiple extrusion and/or rolling into a monofilament, and if necessary, by means of bundling of several monofilaments, and possibly by means of singular or multiple extrusion and/or rolling into a multifilament.

15. Method according to one of the claims 1 to 14, **characterized in that** the shaped body, the tube filled with the shaped body (bodies), or the processed shaped body is/are annealed at temperatures of 400 to 900°C, in case of materials on (Y,SE)-Ea-Cu-O basis even up to 1100°C.

16. Method according to one of the claims 1 to 15, **characterized in that** the shaped body, the tube filled with the shaped body (bodies), and/or the processed shaped body is/are annealed by means of at least one thermal intermediate, and/or after-treatment.

17. Method according to one of the claims 1 to 16, **characterized in that** the shaped body, the tube filled with the shaped body (bodies), or the processed shaped body is/are alternately annealed and rolled multiple times.

18. Method according to one of the claims 1 to 17, **characterized in that** the supraconductor material, or the annealed high-temperature material contains at least one of the supraconductive phases with a composition essentially on (Bi, Pb) -Ea-Cu-O, (Y, SE) -Ea-Cu-O, or (TI, Pb) - (Ea, Y) -Cu-O basis, wherein Ea stands for alkaline earth elements, and particularly stands for Ba, Ca, and/or Sr.

19. Method according to claim 18, **characterized in that** an additive of sulfate(s) is added to the base powder mixture, the supraconductor material, or the annealed high-temperature supraconductor material so that in addition to the supraconductor phase or phases a content of alkaline earth sulfates, particularly of BaSO₄, SrSO₄, and/or (Ba, Sr)SPO₄) occurs.

## Revendications

1. Procédé pour fabriquer un corps moulé, dans lequel un mélange de poudre de départ oxydique ou un matériau supraconducteur, qui contient au moins 30 % en volume de particules primaires en forme de plaquettes et est composé de telle sorte que, avec un traitement thermique approprié ultérieur, un matériau supraconducteur à température élevée est formé, est concassé par broyage, cisaillement et/ou laminage de telle sorte que la poudre concassée présente une répartition granulométrique de poudre avec une valeur d₉₀ ≤ 20 µm et dans lequel les poudres ainsi concassées sont compactées de façon isostatique avec le procédé de matrice sèche.

2. Procédé selon la revendication 1, **caractérisé en ce que** le mélange de poudre de départ et/ou le matériau supraconducteur est concassé de telle sorte qu'au maximum 90 % en volume des particules de poudre sont présentes pour le façonnage sous forme de plaquettes.

3. Procédé selon la revendication 1 ou 2, **caractérisé en ce que** le mélange de poudre de départ ou le matériau supraconducteur est concassé avec un broyeur vibrant, un broyeur à jet et/ou un broyeur à cylindres de cisaillement.

4. Procédé selon l'une quelconque des revendications 1 à 3, **caractérisé en ce que** le mélange de poudre de départ ou le matériau supraconducteur est traité thermiquement avant et/ou après le concassage de sorte que la fraction de particules primaires en forme de plaquettes est augmentée jusqu'à au moins 40 % en volume, en particulier jusqu'à au moins 60 % en volume, et surtout jusqu'à au moins 75 % en volume.

5. Procédé selon l'une quelconque des revendications 1 à 4, **caractérisé en ce que** des produits auxiliaires organiques sont ajoutés au mélange de poudre de départ ou au matériau supraconducteur et **en ce qu'**une poudre coulante est générée lors du concassage dans l'état sec ou dans l'état pratiquement sec.

6. Procédé selon l'une quelconque des revendications 1 à 5, **caractérisé en ce que** la poudre concassée est formée pour retenir des corps moulés essentiellement cylindriques, prismatiques ou tubulaires.

7. Procédé selon l'une quelconque des revendications 1 à 6, **caractérisé en ce que** les poudres concassées sont formées en corps moulés allongés avec un rapport entre la longueur et le diamètre extérieur ou entre la longueur et la plus grande épaisseur d'au moins 2/1, en particulier d'au moins 4/1.

8. Procédé selon l'une quelconque des revendications 1 à 7, **caractérisé en ce qu'**au moins un corps métallique allongé est intégré dans le corps moulé lors du façonnage.

9. Procédé selon la revendication 8, **caractérisé en ce que** le ou chaque corps métallique allongé est intégré comme âme dans le sens longitudinal dans la zone de l'axe longitudinal ou autour de l'axe longitudinal du corps moulé.

10. Procédé selon l'une quelconque des revendications 8 ou 9, **caractérisé en ce que** le ou chaque corps allongé et/ou le tube est essentiellement à base d'au moins un métal ou d'au moins un alliage et contient de préférence de l'argent.

11. Procédé selon l'une quelconque des revendications 1 à 10, **caractérisé en ce qu'**un outil multiple est utilisé pour le compactage isostatique.

12. Procédé selon l'une quelconque des revendications 1 à 11, **caractérisé en ce que** le ou chaque corps moulé est introduit dans un tube de forme essentiellement cylindrique ou prismatique, en particulier dans un tube métallique fermé d'un côté, de préférence métallique.

13. Procédé selon l'une quelconque des revendications 1 à 12, **caractérisé en ce que** des matières auxiliaires organiques sont enlevées par chauffage, cuisson ou désorption chimique.

14. Procédé selon l'une quelconque des revendications 7 à 13, **caractérisé en ce que** le corps moulé est retraité par extrusion unique ou multiple et/ou laminage pour former un monofilament et éventuellement par regroupement de plusieurs monofilaments et éventuellement en supplément par extrusion unique ou multiple et/ou laminage pour former un multifilament.

15. Procédé selon l'une quelconque des revendications 1 à 14, **caractérisé en ce que** le corps moulé, le tube rempli de corps moulé(s) ou le corps moulé retraité est recuit à des températures de 400 à 900°C, et même jusqu'à 1100°C dans le cas de matériaux à base de (Y, SE)-Ea-Cu-O.

16. Procédé selon l'une quelconque des revendications 1 à 15, **caractérisé en ce que** le corps moulé, le tube rempli de corps moulé(s) ou le corps moulé retraité est recuit par au moins un traitement intermédiaire et/ou un retraitement thermique.

17. Procédé selon l'une quelconque des revendications 1 à 16, **caractérisé en ce que** le corps moulé, le tube rempli de corps moulé(s) ou le corps moulé retraité est recuit alternativement plusieurs fois et laminé.

18. Procédé selon l'une quelconque des revendications 1 à 17, **caractérisé en ce que** le matériau supraconducteur ou le matériau recuit et supraconducteur à haute température contient au moins l'une des phases supraconductrices avec une composition essentiellement à base de (Bi,Pb)-Ea-Cu-O, (Y-SE)-Ea-Cu-O ou (TI,Pb)-(Ea,Y)-Cu-O, Ea représentant des éléments alcalinoterreux et en particulier Ba, Ca ou/et Sr.

19. Procédé selon la revendication 18, **caractérisé en ce qu'**un supplément de sulfate(s) est ajouté au mélange de poudre de départ, au matériau supraconducteur ou au matériau supraconducteur à température élevée et recuit, de sorte que, parallèlement à la ou aux phases supraconductrices, il apparaît une teneur en sulfates alcalino-terreux, en particulier en BaSO₄, Sr SO₄ ou/et (Ba, Sr)SO₄.
